# EUROPEAN PATENT APPLICATION

(11) **EP 4 131 397 A1**
(43) Date of publication of application: **08.02.2023**
(21) Application number: 20904239.9
(22) Date of filing: 27.03.2020
(51) Int. Cl.: H01L 27/32, G02F 1/1335, H01L 51/52, G09F 9/33

(54) **DISPLAY SUBSTRATE AND MANUFACTURING METHOD THEREFOR, AND DISPLAY APPARATUS**

(71) Applicant: BOE Technology Group Co., Ltd., Beijing 100015 (CN)
(72) Inventor: DONG, Yongfa, Beijing 100176 (CN); HUANG, Kuanta, Beijing 100176 (CN); LI, Shipeng, Beijing 100176 (CN); WANG, Qing, Beijing 100176 (CN); YUAN, Xiong, Beijing 100176 (CN); SHEN, Xiaobin, Beijing 100176 (CN); TONG, Hui, Beijing 100176 (CN); WANG, Yu, Beijing 100176 (CN)
(74) Representative: Durán-Corretjer, S.L.P.
(86) International application number: PCT/CN2020/081840
(87) International publication number: WO 2021/189475

(57) **Abstract**

Provided are a display substrate and a manufacturing method thereof, and a display apparatus. The display substrate includes: a display area and a peripheral area surrounding the display area. The display substrate includes: a base substrate, and a light emitting structure layer, a color filter layer, a first flat layer and an optical layer disposed on the base substrate; the color filter layer is located on one side of the light emitting structure layer away from the base substrate, the first flat layer is located on one side of the color filter layer away from the base substrate, and the optical layer is located on one side of the first flat layer away from the base substrate and is configured to collect light emitted from the color filter layer. The display substrate further includes: a transistor, and an active layer of the transistor is formed in an interior of the base substrate; a surface of the color filter layer, located in the display area, away from the base substrate is uneven; a first thickness is a maximum thickness of the color filter layer located in the display area, and a second thickness is a minimum thickness of the color filter layer located in the display area; and a difference between the first thickness and the second thickness is smaller than or equal to a thickness of the first flat layer.

## Description

### Technical Field

The present disclosure relates to, but is not limited to, the field of display technology, and particularly relates to a display substrate and a manufacturing method thereof, and a display apparatus.

### Background

A Micro Organic Light-Emitting Diode (Micro-OLED) is a micro-display that has been developed in recent years, which is also called a silicon-based OLED. A silicon-based OLED can not only realize active addressing of pixels, but also enable the preparation of various functional circuits including a timing control (TCON) circuit, an over-current protection (OCP) circuit, etc., on a silicon-based underlay substrate, which is conducive to reducing the system volume and realizing light weight. A silicon-based OLED is prepared by the mature Complementary Metal Oxide Semiconductor (CMOS) integrated circuit technology, has the advantages of small volume, high resolution (Pixels Per Inch (PPI)), high refresh rate, etc., and is widely used in the near-eye display field of Virtual Reality (VR) or Augmented Reality (AR).

A silicon-based OLED generally cannot achieve high display brightness, thus the display effect of the silicon-based OLED is poor.

### Summary

The following is a summary of the subject matter described in detail in the present disclosure. This summary is not intended to limit the protection scope of the claims.

In a first aspect, the present disclosure provides a display substrate, including: a display area and a peripheral area surrounding the display area. The display substrate includes: a base substrate, and a light emitting structure layer, a color filter layer, a first flat layer and an optical layer disposed on the base substrate; the color filter layer is located on one side of the light emitting structure layer away from the base substrate, the first flat layer is located on one side of the color filter layer away from the base substrate, and the optical layer is located on one side of the first flat layer away from the base substrate and is configured to collect light emitted from the color filter layer.

The display substrate further includes: a transistor, an active layer of the transistor is formed in an interior of the base substrate.

A surface of the color filter layer, located in the display area, away from the base substrate is uneven; a first thickness is a maximum thickness of the color filter layer located in the display area, and a second thickness is a minimum thickness of the color filter layer located in the display area.

A difference between the first thickness and the second thickness is smaller than or equal to a thickness of the first flat layer.

In some possible implementations, the optical layer includes: a plurality of optical elements, and light filters correspond to the optical elements one by one.

An orthographic projection of the light filter on the base substrate covers an orthographic projection of a corresponding optical element on the base substrate, and a projection area of the light filter on the base substrate is greater than a projection area of a corresponding optical element on the base substrate.

In some possible implementations, the display substrate further includes: a second flat layer.

The second flat layer is located between the light emitting structure layer and the color filter layer.

In some possible implementations, the display substrate further includes: an optical base layer.

The optical base layer is located between the first flat layer and the optical layer and is configured to adhere the optical layer to the first flat layer.

In some possible implementations, the plurality of optical elements are arranged at intervals and arranged in a matrix.

An interval between adjacent optical elements is smaller than a length of the optical element in a direction perpendicular to the base substrate, and is 0.2 microns to 0.4 microns.

The length of the optical element in the direction perpendicular to the base substrate is smaller than a length of the optical element in an extending direction of the base substrate.

The length of the optical element in the direction perpendicular to the base substrate is 1 micron to 2 microns, and the length of the optical element in the extending direction of the base substrate is 2 microns to 4 microns.

In some possible implementations, the optical element is a lens.

A shape of the lens includes: a hemisphere.

In some possible implementations, lengths of the first flat layer and the second flat layer in a direction perpendicular to the base substrate are 0.3 microns to 0.5 microns.

The length of the first flat layer in the direction perpendicular to the base substrate is greater than the length of the second flat layer in the direction perpendicular to the base substrate.

The length of the first flat layer in the direction perpendicular to the base substrate is smaller than the length of the optical element in the direction perpendicular to the base substrate.

In a possible implementation, a shape of the light filter includes: a hexagon, and the plurality of light filters are arranged in an array.

The second thickness is 1.5 microns to 2.5 microns, and the difference between the first thickness and the second thickness is 0.2 microns to 0.4 microns.

In some possible implementations, the display substrate further includes: an array structure layer.

The array structure layer is located between the base substrate and the light emitting structure layer.

In some possible implementations, the display substrate further includes: an encapsulation layer.

The encapsulation layer is located on one side of the light emitting structure layer close to the second flat layer.

The encapsulation layer includes: a first inorganic encapsulation layer, a second inorganic encapsulation layer and a third organic encapsulation layer.

The first inorganic encapsulation layer is located on one side of a second electrode away from the base substrate.

The second inorganic encapsulation layer is located on one side of the first inorganic encapsulation layer away from the base substrate.

The third organic encapsulation layer is located on one side of the second inorganic encapsulation layer away from the base substrate.

In some possible implementations, a manufacturing material of the third organic encapsulation layer is the same as a manufacturing material of the optical base layer.

In some possible implementations, the display substrate further includes: a cover panel and a filling adhesive.

The cover panel is located on one side of the optical layer away from the base substrate.

The filling adhesive is filled between the cover panel and the optical layer.

In some possible implementations, a thickness of the color filter layer is 1.5 microns to 2.5 microns.

A shape of the light filter is a hexagon, and the plurality of light filters are arranged in an array.

In some possible implementations, the display substrate further includes: a binding area; the binding area is located on one side of the peripheral area away from the display area.

The color filter layer and the light emitting structure layer are located in the display area and part of the peripheral area.

The first flat layer, the second flat layer, and the optical base layer cover the entire display area and at least part of the peripheral area.

In a second aspect, the present disclosure further provides a display apparatus, including the display substrate.

In a third aspect, the present disclosure further provides a method for manufacturing a display substrate, which is used for manufacturing the display substrate described above.

The method includes: forming a light emitting structure layer on a base substrate; forming a color filter layer on one side of the light emitting structure layer away from the base substrate; forming a first flat layer on one side of the color filter layer away from the base substrate; and forming an optical layer on one side of the first flat layer away from the base substrate.

In some possible implementations, the forming a light emitting structure layer on a base substrate includes: forming an array structure layer on the base substrate; forming a first electrode on one side of the array structure layer away from the base substrate; forming a pixel definition layer on one side of the array structure layer, which has the first electrode formed, away from the base substrate; and forming an organic light emitting layer and a second electrode sequentially on one side of the array structure layer, which has the pixel definition layer formed, away from the base substrate.

In some possible implementations, the forming a color filter layer on one side of the light emitting structure layer away from the base substrate includes: forming an encapsulation layer on one side of the light emitting structure layer away from the base substrate; forming a second flat layer on one side of the encapsulation layer away from the base substrate; and forming the color filter layer on one side of the second flat layer away from the base substrate.

In some possible implementations, the forming an optical layer on one side of the first flat layer away from the base substrate includes: forming an optical base layer on one side of the first flat layer away from the base substrate; and forming the optical layer on one side of the optical base layer away from the base substrate.

In some possible implementations, the forming an optical layer on one side of the optical base layer away from the base substrate includes: coating a photoresist thin film onto one side of the optical base layer away from the base substrate; treating the photoresist thin film by a photolithography process to form an initial optical layer; and baking the initial optical layer to form an optical layer including a plurality of optical elements.

In some possible implementations, the treating the photoresist thin film by a photolithography process includes: exposing the photoresist thin film by using a mask to enable the photoresist thin film to include an exposed area and a non-exposed area; an orthographic projection of the pixel definition layer on the base substrate covering an orthographic projection of the exposed area on the base substrate, and a width of the exposed area being smaller than an interval between two adjacent optical devices; and removing the mask, developing the photoresist thin film, and removing the photoresist thin film located in the exposed area.

In some possible implementations, after the forming an optical layer on one side of the color filter layer away from the base substrate, the method further includes: coating a filling adhesive onto one side of the optical layer away from the base substrate; and attaching a cover panel to the filling adhesive.

Other aspects will become apparent upon reading and understanding accompanying drawings and the detailed description.

### Brief Description of Drawings

Accompanying drawings are used to provide an understanding of technical solutions of the present disclosure and form a part of the specification. Together with embodiments of the present disclosure, they are used to explain technical solutions of the present disclosure and do not constitute a limitation on the technical solutions of the present disclosure.
FIG. 1 is a schematic structural diagram of a display substrate according to an embodiment of the present disclosure.
FIG. 2 is a schematic structural diagram of a display substrate according to an exemplary embodiment.
FIG. 3 is a sectional view taken in an A-A direction in FIG. 2.
FIG. 4 is a sectional view taken in a B-B direction in FIG. 2.
FIG. 5 is a schematic diagram of a circuit principle of a base substrate according to an exemplary embodiment.
FIG. 6 is a schematic diagram of circuit implementation of a voltage control circuit and a pixel driving circuit according to an exemplary embodiment.
FIG. 7 is a schematic structural diagram of an organic light emitting layer according to an exemplary embodiment.
FIG. 8 is a flowchart of a method for manufacturing a display substrate according to an embodiment of the present disclosure.
FIG. 9 is a partial top view of a mask according to an exemplary embodiment.
FIG. 10 is a sectional view taken in a C-C direction in FIG. 9.
FIG. 11 to FIG. 22 are schematic diagrams of a method for manufacturing a display substrate according to an exemplary embodiment.

### Detailed Description

To make the objects, technical solutions and advantages of the present disclosure more clear, embodiments of the present disclosure will be described in detail below with reference to the accompanying drawings. The embodiments may be implemented in a number of different forms. A person of ordinary skills in the art may readily understand the fact that implementations and contents may be transformed into a variety of forms without departing from the spirit and scope of the present disclosure. Therefore, the present disclosure should not be construed as being limited only to what is described in the following embodiments. Without conflict, embodiments in the present disclosure and features in the embodiments may be combined with each other arbitrarily.

In the drawings, the size of each constituent element, or the thickness or area of a layer, is sometimes exaggerated for clarity. Therefore, an embodiment of the present disclosure is not necessarily limited to the size shown, and the shape and size of each component in the drawings do not reflect true proportions. In addition, the drawings schematically show ideal examples, and an embodiment of the present disclosure is not limited to the shapes or values shown in the drawings.

Unless otherwise defined, technical terms or scientific terms used in the present disclosure shall have ordinary meanings understood by those of ordinary skills in the field to which the present disclosure pertains. The words "first", "second" and the like used in the present disclosure do not indicate any order, quantity or importance, but are only used to distinguish different components. Similar words such as "including" or "containing" mean that elements or articles appearing before the word cover elements or articles listed after the word and their equivalents, without excluding other elements or articles. Similar words such as "connect" or "link" are not limited to physical or mechanical connections, but may include electrical connections, whether direct or indirect. "Up", "down", "left", "right", etc. are only used to represent a relative position relationship that may change accordingly when an absolute position of an object being described changes.

In this specification, a transistor refers to an element including at least three terminals, namely a gate electrode, a drain electrode and a source electrode. The transistor has a channel region between the drain electrode (a drain terminal, a drain region or a drain electrode) and the source electrode (a source electrode terminal, a source region or a source electrode), and current can flow through the drain electrode, the channel region and the source electrode. The channel region refers to a region through which current mainly flows.

In this specification, a first electrode may be a drain electrode and a second electrode may be a source electrode, or a first electrode may be a source electrode and a second electrode may be a drain electrode. In a case where transistors with opposite polarities are used or the direction of current changes during circuit operation, the functions of the "source electrode" and the "drain electrode" are sometimes interchanged. Therefore, in this specification, "source electrode" and "drain electrode" may be interchanged.

In this specification, "connection" includes a case where the constituent elements are connected together by an element having a certain electrical function. The "element having a certain electrical function" is not particularly limited as long as it can transmit and receive electrical signals between connected components. Examples of the "element having a certain electrical function" not only include electrodes and wirings, but also include switching elements such as transistors, resistors, inductors, capacitors, and other elements with various functions.

In this specification, "film" and "layer" can be interchanged. For example, "conductive layer" can sometimes be replaced by "conductive film". Similarly, "insulating film" can sometimes be replaced by "insulating layer".

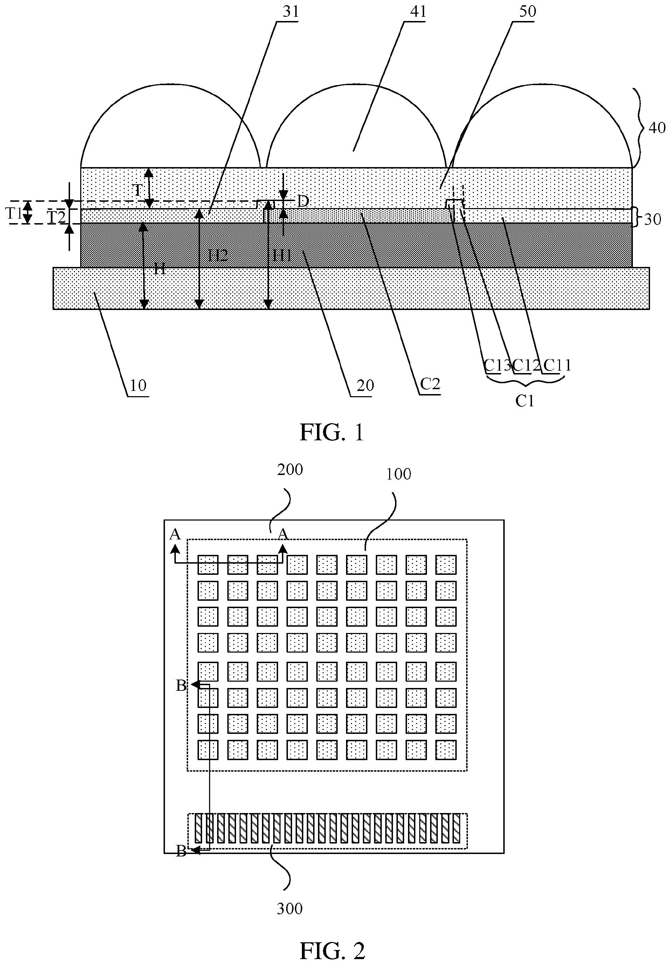

FIG. 1 is a schematic structural diagram of a display substrate according to an embodiment of the present disclosure. As shown in FIG. 1, the display substrate according to an embodiment of the present disclosure includes a display area and a peripheral area surrounding the display area. The display substrate includes: a base substrate 10, and a light emitting structure layer 20, a color filter layer 30, a first flat layer 50 and an optical layer 40 disposed on the base substrate 10. The color filter layer 30 is located on one side of the light emitting structure layer 20 away from the base substrate 10. The first flat layer 50 is located on one side of the color filter layer 30 away from the base substrate 10, and the optical layer 40 is located on one side of the first flat layer 50 away from the base substrate 10 and is configured to collect light emitted from the color filter layer 30. FIG. 1 shows only the display area.

The display substrate further includes: a transistor (not shown); and an active layer of the transistor is formed in an interior of the base substrate. A surface of the color filter layer 30, located in the display area, away from the base substrate 10 is uneven. A first thickness T1 is a maximum thickness of the color filter layer located in the display area, and a second thickness T2 is a minimum thickness of the color filter layer located in the display area.

A difference D between the first thickness T1 and the second thickness T2 is smaller than or equal to a thickness T of the first flat layer 50.

As shown in FIG. 1, the color filter layer 30 located in the display area includes: a plurality of light filters 31.

In an exemplary embodiment, there is an overlap between two adjacent light filters, and the thickness of the color filter layer located in the display area is uneven, which makes the surface of the color filter layer uneven. Two adjacent light filters include: a first light filter C1 and a second light filter C2.

In an exemplary embodiment, the first light filter C1 includes: a first light filter portion C11, a second light filter portion C12 and a third light filter portion C13. An interval between the second light filter portion C12 and the first light filter portion C11 is 0, and an interval between the second light filter portion C12 and the second light filter C2 is 0.

In an exemplary embodiment, there is no overlapping area between orthographic projections of the first light filter portion C11 and the second light filter portion C12 on the base substrate 10 and an orthographic projection of the second light filter C2 on the base substrate 10, and the orthographic projection of the second light filter C2 on the base substrate 10 covers an orthographic projection of the third light filter portion C13 on the base substrate 10.

A distance between a surface of the first light filter portion C11 away from the base substrate and the base substrate is smaller than a distance between a surface of the third light filter portion C13 away from the base substrate and the base substrate, and a thickness of the second light filter portion C12 is equal to the sum of thicknesses of the first light filter portion C1 1 and the third light filter portion C13.

The first thickness is the maximum value of the thickness of the second light filter portion among all adjacent two light filters, that is, the first thickness T1 is the thickness of a light filter in an overlapping area. The first thickness T1 includes: a thickness of an individual light filter and thicknesses of other light filters overlapping the light filter.

The second thickness T2 is the minimum value of the thicknesses of all first light filter portions, the thicknesses of the second light filter portions and the thicknesses of the second light filters, that is, the second thickness is the minimum value of the thicknesses of the light filters which are not in an overlapping area.

In an exemplary embodiment, the second thickness T2 is 1.5 microns to 2.5 microns.

In an exemplary embodiment, the difference D between the first thickness T1 and the second thickness T2 is 0.2 microns to 0.4 microns.

In an exemplary embodiment, a first distance H1 is the maximum distance between the surface of the color filter layer located in the display area away from the base substrate 10 and the base substrate. A second distance H2 is the minimum distance between the surface of the color filter layer located in the display area away from the base substrate and the base substrate. The difference between the first distance H1 and a distance H between a surface of the color filter layer located in the display area close to the base substrate and the base substrate is equal to the first thickness T1, and the difference between the second distance H2 and the distance H between the surface of the color filter layer located in the display area close to the base substrate and the base substrate is equal to the second thickness T2. The difference between the first distance H1 and the second distance H2 is equal to the difference between the first thickness T1 and the second thickness T2, which is an offset of the color filter layer located in the display area.

In an exemplary embodiment, the base substrate 10 may be a silicon-based underlay substrate or a glass underlay substrate.

In an exemplary embodiment, the transistor may be a metal-oxide-semiconductor field-effect transistor.

In an exemplary embodiment, the color filter layer 30 realizes full color display by combining white light with color filters.

In an exemplary embodiment, the color filter layer 30 may further include a black matrix.

In an exemplary embodiment, a high resolution of more than 2000 can be realized by combining white light with color filters, which can meet the requirement of VR/AR.

In an exemplary embodiment, the display substrate may be a top emission structure.

When the surface of a film layer under the color filter layer away from the base substrate is uneven, the distance H between the surface of the color filter layer located in the display area close to the base substrate and the base substrate is not always the same.

In an exemplary embodiment, the difference between the first thickness T1 and the second thickness T2 being smaller than or equal to the thickness T of the first flat layer 50 can ensure that the flat layer can cover the unevenness on the surface of the color filter layer, so as to ensure the uniformity of the optical layer.

In an exemplary embodiment, a manufacturing material of the first flat layer 50 is an organic material.

As shown in FIG. 1, there is a certain overlap between the boundaries of light filters of different colors in the display substrate. Since the size of pixels in the display substrate is very small, an edge of a light filter will be superimposed on a previously manufactured light filter, resulting in thickness difference between the light filters, thereby resulting in unevenness of the color filter layer. Arranging the first flat layer 50 between the color filter layer 30 and the optical layer 40 can ensure that at the time of manufacturing the optical layer, the optical elements are uniform in shape and appearance, so as to maximize the function of the optical layer, thereby ensuring the stability and uniformity of each optical element in the optical layer, which realizes the uniformity of display brightness of the display substrate and improves the display effect of the display substrate.

The display substrate according to an embodiment of the present disclosure includes a display area and a peripheral area surrounding the display area. The display substrate includes: a base substrate, and a light emitting structure layer, a color filter layer, a first flat layer and an optical layer disposed on the base substrate. The color filter layer is located on one side of the light emitting structure layer away from the base substrate, the first flat layer is located on one side of the color filter layer away from the base substrate, and the optical layer is located on one side of the first flat layer away from the base substrate and is configured to collect light emitted from the color filter layer. The display substrate further includes: a transistor, and an active layer of the transistor is formed in an interior of the base substrate. A surface of the color filter layer located in the display area away from the base substrate is uneven. A first thickness is the maximum thickness of the color filter layer located in the display area, and a second thickness is the minimum thickness of the color filter layer located in the display area; and a difference between the first thickness and the second thickness is smaller than or equal to a thickness of the first flat layer. In an embodiment of the present disclosure, by arranging the first flat layer and the optical layer in the display substrate to collect the light emitted by the color filter layer, the display brightness of the display substrate can be improved, which improves the display effect of the silicon-based OLED.

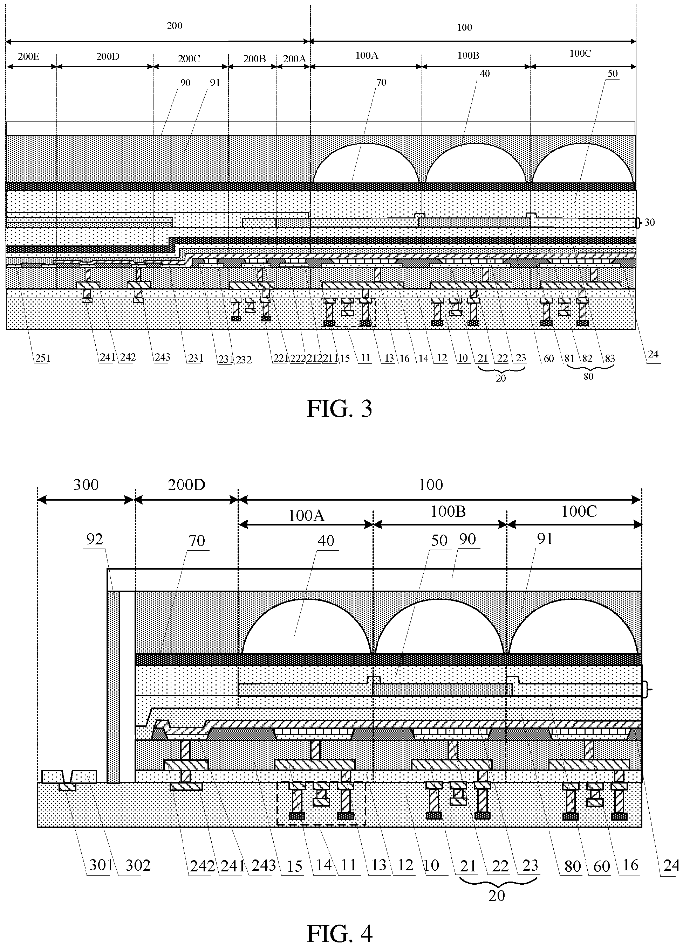

FIG. 2 is a schematic structural diagram of a display substrate according to an exemplary embodiment, FIG. 3 is a sectional view taken in an A-A direction in FIG. 2, and FIG. 4 is a sectional view taken in a B-B direction in FIG. 2. As shown in FIG. 2, a display substrate according to an exemplary embodiment includes: a display area 100, a peripheral area 200 surrounding the display area 100, and a binding area 300 disposed on one side of the peripheral area 200 away from the display area 100.

In an exemplary embodiment, a plurality of sub-pixels arranged regularly are arranged in the display area 100. Each sub-pixel includes: a light emitting element and a pixel driving circuit for driving the light emitting element to emit light. A control circuit for supplying a control signal to the pixel driving circuit is disposed in the peripheral area 200. A pad assembly for binding to an external Flexible Printed Circuit (FPC) is disposed in the binding area 300. In FIGS. 3 and 4, three sub-pixels 100A, 100B and 100C in the display area are taken as an example for illustration.

In an exemplary embodiment, as shown in FIG. 3, the peripheral area 200 includes: a first area 200A, a second area 200B, a third area 200C, a fourth area 200D and a fifth area 200E that are sequentially distributed in the extending direction of the base substrate from the display area to the peripheral area.

In an exemplary embodiment, the transistor may include: a switching transistor and a driving transistor. Transistors on the base substrate 10 may constitute a pixel driving circuit.

In an exemplary embodiment, as shown in FIGS. 3 and 4, transistors 11 are located in the display area 100 and the second area 200B.

In an exemplary embodiment, the transistor includes: an active layer, a gate electrode, a source electrode, a drain electrode and a gate connection electrode. The source electrode and the drain electrode are respectively connected with the active layer, and the gate connection electrode is connected with the gate electrode through a conductive pillar. The transistor may be a bottom gate structure, or may be a top gate structure.

In an exemplary embodiment, a manufacturing material of the active layer may include: a metal oxide.

In an exemplary embodiment, as shown in FIGS. 3 and 4, the display substrate further includes: an array structure layer disposed between the base substrate 10 and the light emitting structure layer 20. The array structure layer includes: a first insulating layer 12, a first conductive pillar 13, a reflective electrode 14, a second insulating layer 15 and a second conductive pillar 16 that are sequentially arranged on the base substrate 10.

In an exemplary embodiment, as shown in FIGS. 3 and 4, the array structure layer covers the entire display area 100 and peripheral area 200.

The first insulating layer 12 and the second insulating layer 15 cover the entire display area and at least part of the peripheral area. In an exemplary embodiment, as shown in FIGS. 3 and 4, the first insulating layer 12 and the second insulating layer 15 cover the entire display area 100 and the entire peripheral area 200.

In an exemplary embodiment, the first conductive pillar 13 and the second conductive pillar 16 are located in the display area 100, the second area 200B and the fourth area 200D.

In an exemplary embodiment, the first insulating layer 12 is provided with a via exposing part of the drain electrode, and the first conductive pillar 13 is arranged in the via of the first insulating layer 12. The reflective electrode 14 is connected to the drain electrode through the first conductive pillar 13. The second insulating layer 15 is provided with a via exposing the reflective electrode 14, and the second conductive pillar 16 is disposed in the via of the second insulating layer 15.

In an exemplary embodiment, the manufacturing material of the first insulating layer 12 and the second insulating layer 15 may be a silicon oxide (SiOx), a silicon nitride (SiNx) or a silicon oxynitride (SiON). The structure of the first insulating layer 12 and the second insulating layer 15 may be a single-layer structure or a multi-layer composite structure.

In an exemplary embodiment, the manufacturing material of the first conductive pillar 13 and the second conductive pillar 16 may be tungsten.

In an exemplary embodiment, the manufacturing material of the reflective electrode 14 may be silver or aluminum. The structure of the reflective electrode 14 may be a single-layer structure or a multi-layer composite structure.

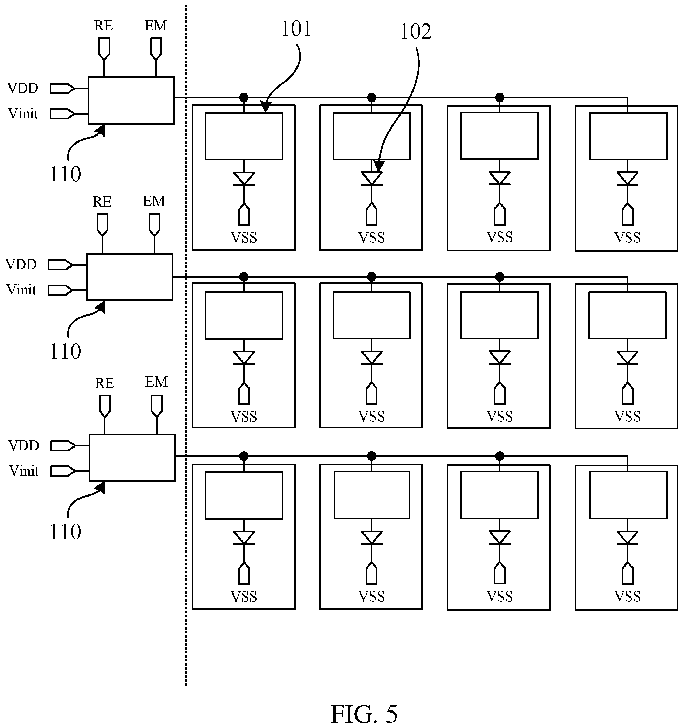

FIG. 5 is a schematic diagram of the circuit principle of a base substrate according to an exemplary embodiment. As shown in FIG. 5, a plurality of sub-pixels in the display area are regularly arranged to form a plurality of display rows and a plurality of display columns. Each sub-pixel includes a pixel driving circuit 101 and a light emitting device 102 connected to the pixel driving circuit 101. The pixel driving circuit 101 includes at least a driving transistor. The control circuit at least includes a plurality of voltage control circuits 110 each connected with a plurality of pixel driving circuits 101. For example, one voltage control circuit 110 is connected to pixel driving circuits 101 in one display row, first electrodes of the driving transistors in pixel driving circuits 101 in the display row are collectively connected to the voltage control circuit 110, the second electrode of each driving transistor is connected to an anode of the light emitting device 102 of the sub-pixel, and a cathode of the light emitting device 102 is connected to an input end of a second power source signal VSS. The voltage control circuit 110 is connected to an input end of a first power source signal VDD, an input end of an initialization signal Vinit, an input end of a reset control signal RE and an input end of a light emitting control signal EM. The voltage control circuit 110 is configured to output, in response to a reset control signal RE, an initialization signal Vinit to a first electrode of a driving transistor to control a corresponding light emitting device 102 to reset. The voltage control circuit 110 is further configured to output, in response to a light emitting control signal EM, a first power source signal VDD to a first electrode of a driving transistor to drive a light emitting device 102 to emit light. By collectively connecting the pixel driving circuits 101 in one display row to the voltage control circuit 110, the structure of the pixel driving circuits 101 in the display area 100 can be simplified, and the occupied area of the pixel driving circuits 101 in the display area 100 can be reduced, so that more pixel driving circuits 101 and light emitting devices 102 can be arranged in the display area 100, realizing high PPI display. Under the control of the reset control signal RE, the voltage control circuit 110 outputs the initialization signal Vinit to the first electrode of the driving transistor and controls the corresponding light emitting device 102 to reset, which can prevent the voltage applied to the light emitting device 102 during light emission of a frame from affecting light emission of a next frame, and can improve image retention.

In an exemplary embodiment, one voltage control circuit 110 may be connected to the pixel driving circuits 101 in two adjacent sub-pixels in the same display row, or may be connected to the pixel driving circuits 101 in three or more sub-pixels in the same display row.

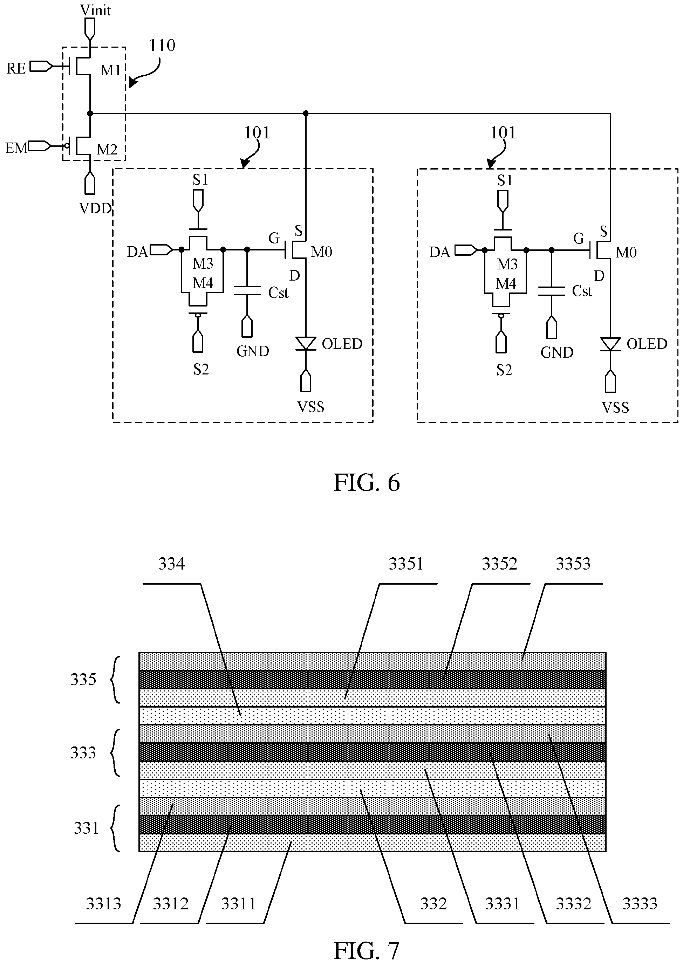

FIG. 6 is a schematic diagram of circuit implementation of a voltage control circuit and a pixel driving circuit according to an exemplary embodiment. As shown in FIG. 6, the light emitting device may include an OLED. An anode of the OLED is connected with the second electrode D of the driving transistor M0, and a cathode of the OLED is connected with the input end of the second power source signal VSS.

In an exemplary embodiment, the voltage of the second power source signal VSS may be a negative voltage or a ground voltage VGND (generally 0V). The voltage of the initialization signal Vinit may be the ground voltage VGND.

In an exemplary embodiment, the OLED may be a Micro-OLED or a Mini-OLED, so as to facilitate the realization of high PPI display.

In an exemplary embodiment, the voltage control circuit 110 is connected with two pixel driving circuits 101 in one display row. The pixel driving circuit 101 includes a driving transistor M0, a third transistor M3, a fourth transistor M4 and a storage capacitor Cst, and the voltage control circuit 110 includes a first transistor M1 and a second transistor M2. The driving transistor M0, the first transistor M1, the second transistor M2, the third transistor M3 and the fourth transistor M4 are all transistors prepared in the base substrate.

A control electrode of the first transistor M1 is connected to the input end of the reset control signal RE and is configured to receive a reset control signal RE. A first electrode of the first transistor M1 is connected to the input end of the initialization signal Vinit and is configured to receive an initialization signal Vinit, and a second electrode of the first transistor M1 is connected to a first electrode S of the corresponding driving transistor M0 and a second electrode of the second transistor M2. A control electrode of the second transistor M2 is connected to the input end of the light emitting control signal EM and is configured to receive a light emitting control signal EM, a first electrode of the second transistor M2 is connected to the input end of the first power source signal VDD and is configured to receive a first power source signal VDD, and the second electrode of the second transistor M2 is connected to the first electrode S of the corresponding driving transistor M0 and the second electrode of the first transistor M1. In an exemplary embodiment, the types of the first transistor M1 and the second transistor M2 may be different, for example, the first transistor M1 is an N-type transistor and the second transistor M2 is a P-type transistor, or the first transistor M1 is a P-type transistor and the second transistor M2 is an N-type transistor. In some possible implementations, the types of the first transistor M1 and the second transistor M2 may be the same, which can be designed and determined according to the actual application environment.

The pixel driving circuit 101 includes a driving transistor M0, a third transistor M3, a fourth transistor M4 and a storage capacitor Cst. A control electrode G of the driving transistor M0 and the first electrode S of the driving transistor M0 are connected to the second electrode of the first transistor M1 and the second electrode of the second transistor M2, and the second electrode D of the driving transistor M0 is connected to the anode of the OLED. A control electrode of the third transistor M3 is connected to an input end of a first control electrode scan signal S1 and is configured to receive a first control electrode scan signal S1, a first electrode of the third transistor M3 is connected to an input end of a data signal DA and is configured to receive a data signal DA, and a second electrode of the third transistor M3 is connected to the control electrode G of the driving transistor M0. A control electrode of the fourth transistor M4 is connected to an input end of a second control electrode scan signal S2 and is configured to receive a second control electrode scan signal S2, a first electrode of the fourth transistor M4 is connected to the input end of the data signal DA and is configured to receive a data signal DA, and a second electrode of the fourth transistor M4 is connected to the control electrode G of the driving transistor M0. A first end of the storage capacitor Cst is connected to the control electrode G of the driving transistor M0, and a second end of the storage capacitor Cst is connected to the ground end GND. In an exemplary embodiment, the driving transistor M0 may be an N-type transistor, and the types of the third transistor M3 and the fourth transistor M4 may be different, for example, the third transistor M3 is an N-type transistor and the fourth transistor M4 is a P-type transistor. When the voltage of the data signal DA is a voltage corresponding to a high gray scale, the P-type fourth transistor M4 is turned on to transmit the data signal DA to the control electrode G of the driving transistor M0, which can prevent the voltage of the data signal DA from being affected by, for example, a threshold voltage of the N-type third transistor M3. When the voltage of the data signal DA is a voltage corresponding to a low gray scale, the N-type third transistor M3 is turned on to transmit the data signal DA to the control electrode G of the driving transistor M0, which can prevent the voltage of the data signal DA from being affected by a threshold voltage of the P-type fourth transistor M4. In this way, it is possible to increase a range of the voltage input to the control electrode G of the driving transistor M0.

In an exemplary embodiment, the types of the third transistor M3 and the fourth transistor M4 may be the following: the third transistor M3 is a P-type transistor and the fourth transistor M4 is an N-type transistor.

In an exemplary embodiment, the pixel driving circuit may be a 3T1C, 5T1C or 7T1C circuit structure, or may be a circuit structure with an internal compensation or external compensation function.

In an exemplary embodiment, as shown in FIGS. 3 and 4, the light emitting structure layer 20 located in the display area 100 includes: a first electrode 21, an organic light emitting layer 22 and a second electrode 23. The first electrode 21 is located on one side of the organic light emitting layer 22 close to the base substrate 10, and is connected with the second conductive pillar 16 in the array structure layer located in the display area. The second electrode 23 is located on one side of the organic light emitting layer 22 away from the base substrate 10.

In an exemplary embodiment, the first electrode 21 is a reflective electrode, and the first electrode 21 may be a multi-layer composite structure.

In an exemplary embodiment, the first electrode 21 may include: a first conductive layer, a second conductive layer and a third conductive layer which are stacked.

In an exemplary embodiment, manufacturing materials of the first conductive layer and the third conductive layer may be titanium. A manufacturing material of the second conductive layer may be aluminum.

FIG. 7 is a schematic structural diagram of an organic light emitting layer according to an exemplary embodiment. As shown in FIG. 7, the organic light emitting layer according to an exemplary embodiment includes a first light emitting sublayer 331, a first charge generating layer 332, a second light emitting sublayer 333, a second charge generating layer 334 and a third light emitting sublayer 335 that are sequentially stacked between the first electrode and the second electrode.

The first light emitting sublayer 331 is configured to emit light of a first color, and includes a first hole transporting layer (HTL) 3311, a first emitting material layer (EML) 3312 and a first electron transporting layer (ETL) 3313 that are stacked in this order. The second light emitting sublayer 333 is configured to emit light of a second color, and includes a second hole transporting layer 3331, a second emitting material layer 3332 and a second electron transporting layer 3333 that are stacked in this order. The third light emitting sublayer 335 is configured to emit light of a third color, and includes a third hole transporting layer 3351, a third emitting material layer 3352 and a third electron transporting layer 3353 that are stacked in this order. The first charge generating layer 332 is disposed between the first light emitting sublayer 331 and the second light emitting sublayer 333, and is configured to connect the two light emitting sublayers in series to realize carrier transfer. The second charge generating layer 334 is disposed between the second light emitting sublayer 333 and the third light emitting sublayer 335, and is configured to connect the two light emitting sublayers in series to realize carrier transfer. Since the organic light emitting layer includes a first emitting material layer emitting light of a first color, a second emitting material layer emitting light of a second color, and a third emitting material layer emitting light of a third color, the light eventually emitted by the organic light emitting layer is mixed light. For example, it may be arranged that the first emitting material layer is a red light material layer emitting red light, the second emitting material layer is a green light material layer emitting green light, and the third emitting material layer is a blue light material layer emitting blue light. Therefore, the organic light emitting layer eventually emits white light.

In practice, the structure of the organic light emitting layer may be designed according to actual needs. In each light emitting sublayer, in order to improve the efficiency of injecting electrons and holes into the emitting material layers, a hole injection layer and an electron injection layer may also be provided. In order to simplify the structure of the organic light emitting layer, the first electron transporting layer 3313, the first charge generating layer 332 and the second hole transporting layer 3331 may be cancelled, that is, the second emitting material layer 3332 may be disposed directly on the first emitting material layer 3312.

In an exemplary embodiment, the organic light emitting layer may be an organic light emitting layer emitting light of the first color and an organic light emitting layer emitting complementary light of the light of the first color, and the two organic light emitting layers are sequentially stacked relative to the base substrate, thereby emitting white light as a whole.

In an exemplary embodiment, the second electrode 23 may be a planar electrode. The second electrode 23 is a transmissive electrode for transmitting light emitted by the organic light emitting layer 22 and reflected by the first electrode 21.

In an exemplary embodiment, the manufacturing material of the second electrode 23 may be indium tin oxide or zinc tin oxide, or may be other transparent conductive materials.

In an exemplary embodiment, the display substrate further includes: M rows of gate lines and N columns of data lines, and the gate lines and the data lines are staggered horizontally and vertically. Each sub-pixel is defined by intersection of the gate lines and the data lines, that is, the display substrate includes: a plurality of sub-pixels arranged in a matrix in the row direction and the column direction.

A plurality of sub-pixels in the display area constitute a pixel. The arrangement of a plurality of sub-pixels in the same pixel may be that the plurality of sub-pixels are located in the same row, that is, the plurality of sub-pixels are arranged in the row direction, or may be that different sub-pixels are located in adjacent rows, and the sub-pixels located in adjacent rows are staggered, for example, in a " 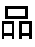 "-shaped arrangement or in other arrangements.

In an exemplary embodiment, as shown in FIG. 1, the plurality of light filters 31 in the color filter layer 30 in the display area are arranged in an array.

In an exemplary embodiment, the shape of the light filter 31 may be hexagonal, elongated or approximately elliptical.

In an exemplary embodiment, the area of the light filter 31 is less than 20 µm2.

In an exemplary embodiment, the preparation temperature of the light filter 31 is less than 90 degrees.

In an exemplary embodiment, the color filter layer 30 includes at least a light filter of a first color, a light filter of a second color, and a light filter of a third color. Alternatively, the color filter layer 30 may also include a white light filter or light filters of other colors.

In an exemplary embodiment, a case where the color filter layer 30 includes a light filter of a first color, a light filter of a second color, and a light filter of a third color is taken as an example. The light filter of the first color, the light filter of the second color and the light filter of the third color included in the color filter layer located in a pixel area are arranged in a manner in which the plurality of sub-pixels in the pixel area are arranged.

In an exemplary embodiment, the light filter of the first color, the light filter of the second color and the light filter of the third color are disposed on the same surface. On a plane parallel to the surface, the light filter of the second color is arranged on a first side of the light filter of the first color, and the light filter of the third color is arranged on a second side of the light filter of the first color opposite to the first side.

In an exemplary embodiment, at least one of the light filter of the second color and the light filter of the third color covers part of the light filter of the first color; at least part of the light filter of the first color does not overlap with the light filter of the second color and the light filter of the third color; and the light filter of the second color and the light filter of the third color do not overlap at all.

In an exemplary embodiment, a patterning process includes: photoresist coating, exposure, development, etching, stripping and other processes.

In an exemplary embodiment, the light filter of the first color is formed by a first patterning process; the light filter of the second color located on the first side of the light filter of the first color is formed by a second patterning process, and the light filter of the second color partially covers the light filter of the first color, which can reduce the contact area between the second color and a film layer under the color filter layer; and then, the light filter of the third color located on the second side of the light filter of the first color is formed by a third patterning process, and the light filter of the third color partially covers the light filter of the second color, which can reduce the contact area between the third color and the film layer under the color filter layer.

In an exemplary embodiment, the light filter of the first color may be a green (G) light filter, the light filter of the second color may be a red (R) light filter, and the light filter of the third color may be a blue (B) light filter. Alternatively, the light filter of the first color may be a blue light filter, the light filter of the second color may be a green light filter, and the light filter of the third color may be a red light filter.

In an exemplary embodiment, the adhesion of the green light filter is greater than the adhesion of the red light filter and the adhesion of the blue light filter.

In an example where the light filter of the first color can be a green (G) light filter, the light filter of the second color can be a red (R) light filter and the light filter of the third color can be a blue (B) light filter, the green light filter with greater adhesion is formed first, and the red light filter with smaller adhesion is formed later, and the red light filter with smaller adhesion partially covers the green light filter with greater adhesion, thus reducing the contact area between the red light filter with smaller adhesion and a film layer under the color filter layer. The green light filter and the red light filter have similar properties, and the adhesive force between the green light filter and the red light filter is greater than that between the red light filter and the film layer below the color filter layer. Thus, compared with the case where the red light filter does not cover the green light filter at all, the red light filter partially covering the green light filter can reduce the possibility of the green light filter and the red light filter being stripped from the film layer under the color filter layer as a whole. In addition, due to the smaller adhesion, the red light filter has good flowability, then in the process of forming the red light filter, the uniformity of film thickness at the overlapping position between the green light filter and the red light filter can be improved. Then, the blue light filter with smaller adhesion is formed, and the blue light filter with smaller adhesion partially covers the green light filter with greater adhesion, so that the contact area between the blue light filter with smaller adhesion and the film layer under the color filter layer can be reduced. The green light filter and the blue light filter have similar properties, and the adhesive force between the green light filter and the blue light filter is greater than that between the blue light filter and the film layer under the color filter layer. Thus, compared with the case where the blue light filter does not cover the green light filter at all, the blue light filter partially covering the green light filter can reduce the possibility of the green light filter and the blue light filter being stripped from the film layer under the color filter layer as a whole. In addition, due to the smaller adhesion, the blue light filter has good flowability, then in the process of forming the blue light filter, the uniformity of film thickness at the overlapping position between the green light filter and the blue light filter can be improved.

In an exemplary embodiment, light filters of the same color located in different pixel areas are formed in the same process.

In an exemplary embodiment, as shown in FIG. 1, the optical layer 40 includes a plurality of optical elements 41, and the light filters 31 correspond to the optical elements 41 one by one. An orthographic projection of the light filter 31 on the base substrate 10 covers an orthographic projection of the corresponding optical element 41 on the base substrate 10, and a projection area of the light filter 31 on the base substrate 10 is greater than that of the corresponding optical element 41 on the base substrate 10.

In an exemplary embodiment, there is no overlapping area between the orthographic projections of adjacent optical elements 41 on the base substrate 10, that is, there is no overlap, but an interval, between adjacent optical elements.

In an exemplary embodiment, the plurality of optical elements 41 are arranged at intervals and arranged in a matrix. There is an interval between adjacent optical elements in the same row, and there is an interval between optical elements in adjacent row.

In an exemplary embodiment, the interval between adjacent optical elements is smaller than the length of the optical element in the direction perpendicular to the base substrate, and is 0.2 microns to 0.4 microns.

In an exemplary embodiment, the length of the optical element 41 in the direction perpendicular to the base substrate is smaller than the length of the optical element in the extending direction of the base substrate.

In an exemplary embodiment, the length of the optical element 41 in the direction perpendicular to the base substrate is 1 micron to 2 microns, and the length of the optical element in the extending direction of the base substrate is 2 microns to 4 microns.

In an exemplary embodiment, the optical element 41 is a lens.

In an exemplary embodiment, a manufacturing material of the lens may be a photoresist material.

In an exemplary embodiment, the lens may be hemispherical, or may have other shapes that can collect light.

In an exemplary embodiment, the optical layer is located within the display area. The optical layer may be located in part of the peripheral area to improve the display effect of the display substrate.

In an exemplary embodiment, the shape and size of the optical elements in the optical layer in the peripheral area are similar to the shape and size of the optical elements in the optical layer in the display area.

In an exemplary embodiment, the length of the first flat layer 50 in the direction perpendicular to the base substrate is 0.3 micron to 0.5 micron.

The first flat layer 50 covers the entire display area and at least part of the peripheral area. In an exemplary embodiment, as shown in FIGS. 3 and 4, the first flat layer 50 covers the entire display area 100 and the entire peripheral area 200.

In an exemplary embodiment, as shown in FIGS. 3 and 4, the display substrate further includes a second flat layer 60 between the light emitting structure layer 20 and the color filter layer 30.

In an exemplary embodiment, a manufacturing material of the second flat layer 60 is an organic material.

In an exemplary embodiment, the length of the second flat layer 60 in the direction perpendicular to the base substrate is 0.3 micron to 0.5 micron.

In an exemplary embodiment, the length of the first flat layer 50 in the direction perpendicular to the base substrate is greater than the length of the second flat layer 60 in the direction perpendicular to the base substrate.

In an exemplary embodiment, the length of the first flat layer 50 in the direction perpendicular to the base substrate is smaller than the length of the optical element 41 in the direction perpendicular to the base substrate.

As shown in FIG. 3 and FIG. 4, the unevenness of the second electrode is caused not only by the first electrode, but also by groove or protrusion structures provided to block the lateral current and cross talk or reduce the influence on the uniformity of an evaporation material. The arrangement of the second flat layer between the light emitting structure layer 20 and the color filter layer 30 can ensure uniformity of each light filter at the time of making the color filter layer, which can ensure the normal display of the display substrate.

The second flat layer 60 covers the entire display area and at least part of the peripheral area. In an exemplary embodiment, as shown in FIGS. 3 and 4, the second flat layer 60 covers the entire display area 100 and the entire peripheral area 200.

In an exemplary embodiment, as shown in FIGS. 3 and 4, the display substrate further includes an optical base layer 70. The optical base layer 70 is located between the first flat layer 50 and the optical layer 40, and is configured to adhere the optical layer 40 to the first flat layer 50.

The optical base layer 70 located between the first flat layer 50 and the optical layer 40 can prevent the optical layer from falling off the first flat layer 50.

In an exemplary embodiment, a manufacturing material of the optical base layer 70 may be an organic material, and the organic material may be parylene.

The optical base layer 70 covers the entire display area and at least part of the peripheral area. In an exemplary embodiment, as shown in FIGS. 3 and 4, the optical base layer 70 covers the entire display area 100 and the entire peripheral area 200.

In an exemplary embodiment, as shown in FIGS. 3 and 4, the display substrate further includes an encapsulation layer 80 located on the light emitting structure layer 20 close to the second flat layer 60. The encapsulation layer 80 is used for blocking water and oxygen to protect the light emitting structure layer.

The encapsulation layer 80 covers the entire display area and at least part of the peripheral area. In an exemplary embodiment, as shown in FIGS. 3 and 4, the encapsulation layer 80 covers the entire display area 100 and the entire peripheral area 200.

In an exemplary embodiment, the encapsulation layer 80 includes: a first inorganic encapsulation layer 81, a second inorganic encapsulation layer 82 and a third organic encapsulation layer 83. The first inorganic encapsulation layer 81 is located on one side of the second inorganic encapsulation layer 82 close to the base substrate 10, and the third organic encapsulation layer 83 is located on one side of the second inorganic encapsulation layer 82 away from the base substrate 10.

In an exemplary embodiment, the manufacturing material of the first inorganic encapsulation layer 81 may include silicon nitride. The first inorganic encapsulation layer may prevent damages to the light emitting structure layer at the time of manufacturing the second inorganic encapsulation layer. Due to the inorganic properties, the first inorganic encapsulation layer 81 not only has good encapsulation properties, but also has good adhesion to the second electrode, thus ensuring the encapsulation effect of the encapsulation layer.

In an exemplary embodiment, the manufacturing material of the second inorganic encapsulation layer 82 may include aluminum oxide. The second inorganic encapsulation layer may block water and oxygen from entering the light emitting structure layer, which can prolong the service life of the light emitting structure layer.

In an exemplary embodiment, the thickness of the second inorganic encapsulation layer 82 is greater than that of the first inorganic encapsulation layer 81.

In an exemplary embodiment, the manufacturing material of the third organic encapsulation layer 83 may include parylene. Due to the organic properties, the third organic encapsulation layer 83 not only has relatively good organic encapsulation properties, but also has relatively good particle coating ability, and can well coat the particles on a film layer and prevent them from piercing the film layer. In addition, materials with organic properties can well release the stress between inorganic layers, and prevent the occurrence of defects such as microcracks or peeling in the film layer due to relatively high stress. The third organic encapsulation layer 83 also has relatively good flat properties, and can provide a relatively flat base substrate for the subsequent manufacturing of the color filter layer and prevent the process of the color filter layer from damaging the second inorganic encapsulation layer.

In an exemplary embodiment, manufacturing materials of the third organic encapsulation layer 83 and the optical base layer 70 may be the same.

In an exemplary embodiment, as shown in FIGS. 3 and 4, the display substrate further includes a cover panel 90 and a filling adhesive 91. The cover panel 90 is located on one side of the optical layer 40 away from the base substrate 10. The filling adhesive 91 is filled between the cover panel 90 and the optical layer 40.

In an exemplary embodiment, the cover panel 90 may be a glass cover panel, which can protect the optical layer 40 from damages by external forces.

In an exemplary embodiment, the cover panel 90 covers the entire display area 100 and the entire peripheral area 200.

In an exemplary embodiment, as shown in FIG. 4, the display substrate further includes a sealant 92. The cover panel 90 is fixed to the base substrate 10 by the sealant 92.

In an exemplary embodiment, the sealant 93 is disposed between the base substrate 10 and the cover panel 90, and can provide protection against water and oxygen intrusion and greatly prolong the service life of the silicon-based OLED display substrate. In another exemplary embodiment, the sealant may be arranged on side surfaces of the cover panel, the peripheral side surfaces of the cover panel and the base substrate are sealed by the sealant. An end surface of one side of the sealant away from the base substrate is located between a surface of one side of the cover panel close to the base substrate and a surface of one side of the cover panel away from the base substrate. In this way, it is possible to ensure the sealing effect, and also prevent the sealant from being higher than the cover panel to cause an increase in the thickness of the display substrate.

In an exemplary embodiment, as shown in FIG. 3, the first area 200A includes: a first connection electrode 211, a first organic light emitting layer 212 and a second electrode 23. The first area 200A further includes: a color filter layer disposed on one side of the second electrode 23 away from the base substrate 10 and an optical layer disposed on one side of the color filter layer away from the base substrate.

The first connection electrode 211 located in the first area 200A and the first electrode 21 located in the display area 100 are arranged on the same layer and formed by the same process. The first organic light emitting layer 212 located in the first area 200A and the organic light emitting layer 22 located in the display area 100 are arranged on the same layer and are formed by the same process. Being arranged on the same layer means being located on the surface of the same film layer.

There is an overlap between adjacent light filters in the color filter layer in the first area 200A. The color filter layer located in the first area 200A and the color filter layer located in the display area are formed by the same process. There is an interval between adjacent optical elements in the optical layer located in the first area 200A. The optical layer located in the first area 200A and the optical layer located in the display area 100 are arranged on the same layer and are formed by the same process.

In an exemplary embodiment, the first area 200A is used for ensuring the uniformity of the display of the display substrate.

In an exemplary embodiment, as shown in FIG. 3, the second area 200B includes: an array structure layer, a second connection electrode 221, a second organic light emitting layer 222 and a second electrode 23. The second area 200B further includes a color filter layer disposed on one side of the second electrode 23 away from the base substrate 10.

The second connection electrode 221 located in the second area 200B and the first electrode 21 located in the display area 100 are disposed on the same layer and formed by the same process. The second organic light emitting layer 222 located in the second area 200B and the organic light emitting layer 22 located in the display area 100 are arranged on the same layer and formed by the same process.

There is an overlap between adjacent light filters in the color filter layer located in the second area 200B. The optical layer located in the first area 200A and the optical layer located in the display area 100 are arranged on the same layer and are formed by the same process.

The optical elements in the optical layers located in the first area 200A and the second area 200B and the light filters located in the color filter layers are substantially the same in shape and size as the optical elements and the light filters located in the display area 100. FIG. 3 is only for explaining the positions where the optical elements and the light filters are arranged, which is not used to limit the sizes and shapes of the optical elements and the light filters.

In an exemplary embodiment, the second area 200B is used for simulating detecting the working condition of the display area 100, for example, for detecting data of the display area.

In an exemplary embodiment, a transition area may be included between the first area 200A and the display area 100. The structure of the transition area is the same as the pixel structure and the structures of the light filters and the optical elements in the display area, for adapting to the precision of optical mechanical alignment, so that when there is a deviation in optical alignment, pixels in the transition area are driven to display for compensation.

In an exemplary embodiment, a circle of area of the display area close to the first area 200A is the transition area. The structure of the transition area is the same as the pixel structure and the structures of the light filters and the optical elements in the display area, for adapting to the precision of optical mechanical alignment, so that when there is a deviation in optical alignment, pixels in the transition area are driven to display for compensation. In an exemplary embodiment, driving circuits and signal input (e.g., timing) of the pixels in the transition area may be different from the driving circuits and signal input (e.g., timing) of the pixels in the interior (e.g., a central area) of the display area.

In an exemplary embodiment, the color filter layer 30 includes: a color filter layer located in the display area 100, a color filter layer located in the first area and a color filter layer located in the second area. The boundaries of the color filter layer 30 are located in the second area.

In an exemplary embodiment, the optical layer 40 includes: an optical layer located in the display area, an optical layer located in the first area, and the optical layer located in the second area. The boundaries of the optical layer 40 are located in the second area 200B.

In an exemplary embodiment, as shown in FIG. 3, the third area 200C includes: a plurality of third connection electrodes 231, a second electrode 23, and a third organic light emitting layer 232 on part of the third connection electrodes 231 close to the second area 200B.

The third connection electrodes 231 located in the third area 200C and the first electrode 21 located in the display area 100 are arranged on the same layer and are formed by the same process. The third organic light emitting layer 232 located in the third area 200C and the organic light emitting layer 22 located in the display area 100 are arranged on the same layer and are formed by the same process.

In an exemplary embodiment, the organic light emitting layer includes: an organic light emitting layer 22 in the display area, a first organic light emitting layer 212 in the first area, a second organic light emitting layer 222 in the second area, and a third organic light emitting layer 232 in the third area. The boundaries of the organic light emitting layer are located in the third area 200C.

In an exemplary embodiment, the boundaries of the organic light emitting layers in various areas may or may not coincide. In FIG. 3 and FIG. 4, the case where the boundaries of the organic light emitting layers in various areas do not coincide is taken as an example for illustration.

In an exemplary embodiment, as shown in FIGS. 3 and 4, the fourth area 200D includes: a power supply electrode 241, an auxiliary electrode 242, a fourth connection electrode 243, and a second electrode 23. The auxiliary electrode 242 is connected with the power supply electrode 241 through a first conductive pillar, the fourth connection electrode 243 is connected with the auxiliary electrode 242 through a second conductive pillar, and the fourth connection electrode 243 is directly overlapped with the second electrode 23. The power supply electrode 241 supplies power to the second electrode 23 through the first conductive pillar, the auxiliary electrode 242, the second conductive pillar and the fourth connection electrode 243.

The fourth connection electrode 243 is in direct contact with the second electrode 23, and there is no other film layer therebetween.

In an exemplary embodiment, the power supply electrode 241 in the fourth area 200D and the source and drain electrodes in CMOS in the array structure layer in the display area are arranged on the same layer and are formed by the same process. The auxiliary electrode 242 in the fourth area 200D and the reflective electrode 14 in the array structure layer in the display area are arranged on the same layer and are formed by the same process. The fourth connection electrode 243 located in the fourth area 200D and the first electrode 21 located in the display area are arranged on the same layer and are formed by the same process.

In an exemplary embodiment, the second electrode 23 may be connected with the fourth connection electrode 243 through a via, so that the fourth connection electrode 243 and the auxiliary electrode 242 form a conductive channel between the second electrode 23 and the power supply electrode 241. A voltage signal provided by the power supply electrode 241 is transmitted to the second electrode 23 through the conductive channel. The conductive channel is called a cathode ring structure.

In an exemplary embodiment, a cathode ring is an annular structure located in the peripheral area, which is a conductive channel surrounding the display area to supply power to the second electrode.

In an exemplary embodiment, the second electrode 23 covers the entire display area and part of the peripheral area.

In an exemplary embodiment, as shown in FIG. 3, the fifth area 200E includes a fifth connection electrode 251.

In an exemplary embodiment, the fifth connection electrode 251 located in the fifth area 200E and the first electrode 21 located in the display area 100 are arranged on the same layer and are formed by the same process.

In an exemplary embodiment, the boundary of the second electrode 23 is located in the fifth area 200E.

In an exemplary embodiment, as shown in FIGS. 3 and 4, the display substrate further includes a pixel definition layer 24 located on one side of the array structure layer away from the substrate .

The pixel definition layer 24 is located in the display area and the peripheral area. The pixel definition layer in the display area is used for defining each sub-pixel area. The pixel definition layer located in the peripheral area is used for spacing adjacent electrodes arranged on the same layer as the first electrodes 21 located in the display area 100.

In an exemplary embodiment, a manufacturing material of the pixel definition layer 24 may be polyimide, acrylic or polyethylene terephthalate.

In an exemplary embodiment, as shown in FIG. 4, the binding area 300 includes a binding electrode 301 and a binding pad 302.

In an exemplary embodiment, the binding electrode 301 located in the binding area 300 and the source and drain electrodes of CMOS in the array structure layer located in the display area are arranged on the same layer and formed by the same process.

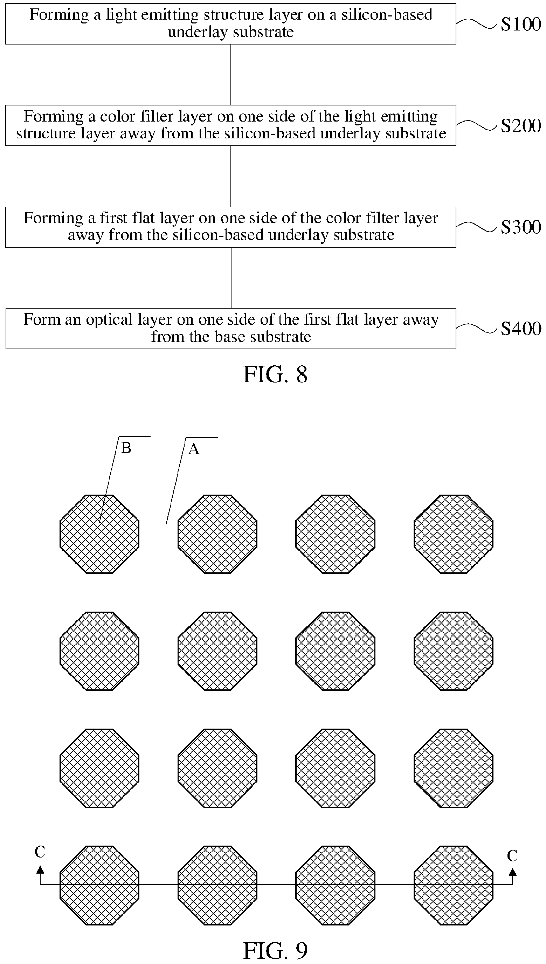

FIG. 8 is a flowchart of a method for manufacturing a display substrate according to an embodiment of the present disclosure. As shown in FIG. 8, an embodiment of the present disclosure further provides a method for manufacturing a display substrate, which is used for manufacturing the display substrate according to any of the previous embodiments. The method for manufacturing a display substrate according to an embodiment of the present disclosure includes the following steps:
Step S100: forming a light emitting structure layer on a base substrate.
Step S200: forming a color filter layer on one side of the light emitting structure layer away from the base substrate.
Step S300: forming a first flat layer on one side of the color filter layer away from the base substrate.
Step S400: form an optical layer on one side of the first flat layer away from the base substrate.

In an exemplary embodiment, the display substrate includes: a display area, a peripheral area and a binding area. The peripheral area includes: a first area to a fifth area sequentially distributed in the extending direction of the base substrate from the display area to the peripheral area.

The method for manufacturing a display substrate according to an embodiment of the present disclosure is used for manufacturing the display substrate according to any of the previous embodiments, with similar implementation principles and implementation effects, which will not be described further here.

In an exemplary embodiment, step S100 includes: forming an array structure layer on the base substrate; forming a first electrode on one side of the array structure layer away from the base substrate; forming a pixel definition layer on one side of the array structure layer, which has the first electrode formed, away from the base substrate; and forming an organic light emitting layer and a second electrode sequentially on one side of the array structure layer, which has the pixel definition layer formed, away from the base substrate.

In an exemplary embodiment, the base substrate includes: CMOS in the display area and the second area, a power supply electrode in the fourth area, and a binding electrode in the binding area.

The forming an array structure layer on the base substrate includes: forming on the base substrate a first insulating layer covering the entire display area and the entire peripheral area and including a via; forming a first conductive pillar in the via of the first insulating layer; forming on the first insulating layer a reflective electrode located in the display area and the second area and an auxiliary electrode located in the fourth area; forming, on the first insulating layer on which the reflective electrode and the auxiliary electrode are formed, a second insulating layer covering the entire display area and the entire peripheral area and including a via; and forming a second conductive pillar in the via of the second insulating layer.

In an exemplary embodiment, the vias of the first insulating layer and the second insulating layer are located in the display area, the second area and the fourth area.

In an exemplary embodiment, the forming a first electrode on one side of the array structure layer away from the base substrate includes: forming, on one side of the array structure layer away from the base substrate, a first electrode located in the display area, a first connection electrode located in the first area, a second connection electrode located in the second area, a third connection electrode located in the third area, a fourth connection electrode located in the fourth area and a fifth connection electrode located in the fifth area.

In an exemplary embodiment, the forming a pixel definition layer on one side of the array structure layer, which has the first electrode formed, away from the base substrate includes: forming, on the array structure layer on which the first electrode is formed, a pixel definition layer located in the display area and the peripheral area.

In an exemplary embodiment, the forming an organic light emitting layer and a second electrode sequentially on one side of the array structure layer, which has the pixel definition layer formed, away from the base substrate, includes: forming an organic light emitting layer located in the display area, a first organic light emitting layer located in the first area, a second organic light emitting layer located in the second area and a third organic light emitting layer located in the third area, on one side of the array structure layer, which has the pixel definition layer formed, away from the base substrate; and forming second electrodes located in the display area, the first area, the second area, the third area, the fourth area and part of the fifth area, on one side of the array structure layer, which has the organic light emitting layer formed, away from the base substrate.

In an exemplary embodiment, step S200 includes: forming an encapsulation layer on one side of the light emitting structure layer away from the base substrate; forming a second flat layer on one side of the encapsulation layer away from the base substrate; and forming the color filter layer on one side of the second flat layer away from the base substrate.

In an exemplary embodiment, the forming an encapsulation layer on one side of the light emitting structure layer away from the base substrate includes: forming a first inorganic encapsulation layer, a second inorganic encapsulation layer and a third organic encapsulation layer sequentially on one side of the light emitting structure layer away from the base substrate to form the encapsulation layer.

In an exemplary embodiment, the forming the color filter layer on one side of the second flat layer away from the base substrate includes: forming, on the second flat layer, a color filter layer located in the display area, the first area and the second area and including light filters arranged in an array.

In an exemplary embodiment, step S400 includes: forming an optical base layer on one side of the first flat layer away from the base substrate; and forming the optical layer on one side of the optical base layer away from the base substrate.

In an exemplary embodiment, the forming an optical layer on one side of the optical base layer away from the base substrate includes: coating a photoresist thin film onto the side of the optical base layer away from the base substrate; treating the photoresist thin film by a photolithography process to form an initial optical layer; and baking the initial optical layer to form an optical layer including a plurality of optical devices through natural flow of the photoresist thin film.

In an exemplary embodiment, the treating the photoresist thin film by a photolithography process includes: exposing the photoresist thin film by using a mask to enable the photoresist thin film to include an exposed area and a non-exposed area; and removing the mask, developing the photoresist thin film, and removing the photoresist thin film located in the exposed area.

In an exemplary embodiment, an orthographic projection of the pixel definition layer on the base substrate covers an orthographic projection of the exposed area on the base substrate, and a width of the exposed area is smaller than an interval between two adjacent optical devices.

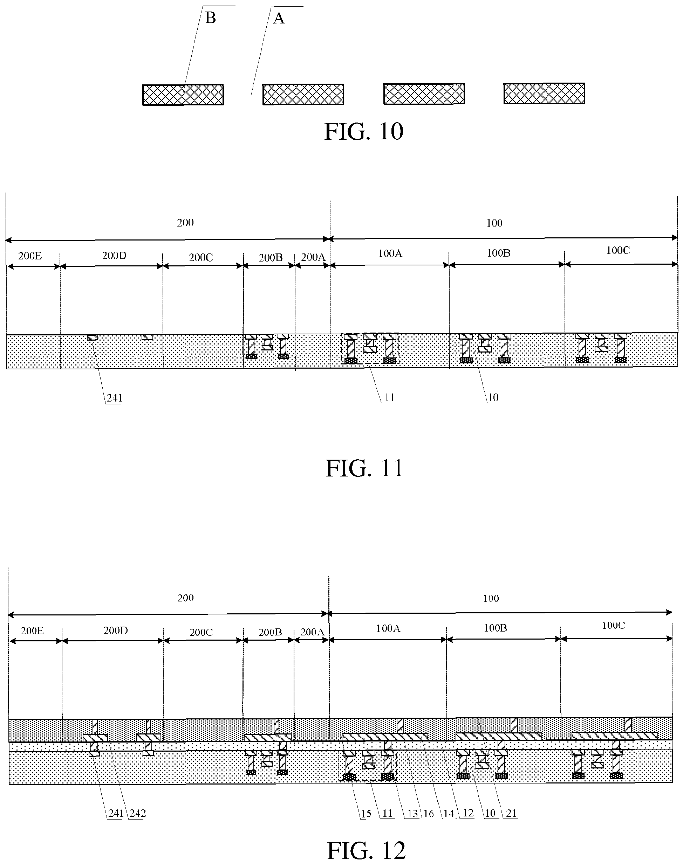

FIG. 9 is a partial top view of a mask according to an exemplary embodiment, and FIG. 10 is a sectional view taken in a C-C direction in FIG. 9. As shown in FIGS. 9 and 10, the mask includes a light transmissive region A and a non-light transmissive region B. After the photoresist thin film is exposed by the mask, the light transmissive region corresponds to the exposed area of the exposed photoresist thin film, and the non-light transmissive region corresponds to the non-exposed area of the exposed photoresist thin film.

In an exemplary embodiment, the light transmissive region A of the mask is a mesh structure, and the non-light transmissive region B includes a plurality of block-shaped non-light transmissive areas arranged in a matrix, and the non-light transmissive areas correspond to the sub-pixels in the display area one by one. The non-light transmissive region B is located at the boundaries of the sub-pixels in the display area.

In an exemplary embodiment, after the optical layer is formed on one side of the color filter layer away from the base substrate, the method for manufacturing a display substrate further includes: coating a filling adhesive onto one side of the optical layer away from the base substrate; and attaching a cover panel to the filling adhesive.

In an exemplary embodiment, after a cover panel is attached to the filling adhesive, the method for manufacturing a display substrate further includes forming a sealant between the cover panel and the base substrate.

A method for manufacturing a display substrate according to an exemplary embodiment is described below with reference to FIGS. 11 to 22.

Step S1 includes: providing a base substrate 10, as shown in FIG. 11.

On the base substrate 10, there are provided an active layer of the transistor 11 located in the display area 100 and the second area 200B, a power supply electrode 241 located in the fourth area 200D and a binding electrode (not shown) located in the binding area, the base substrate 10.

Step S2 includes: forming a first insulating layer 12 on the base substrate 10; forming a first conductive pillar 13 in a via of the first insulating layer 12; forming on the first insulating layer 12 a reflective electrode 14 located in the display area 100 and the second area 200B and an auxiliary electrode 242 located in the fourth area 200D; forming a second insulating layer 15 on the first insulating layer 12 on which the reflective electrode 14 and the auxiliary electrode 242 are formed; and forming a second conductive pillar 16 in a via of the second insulating layer 15 to form an array structure layer, as shown in FIG. 12.

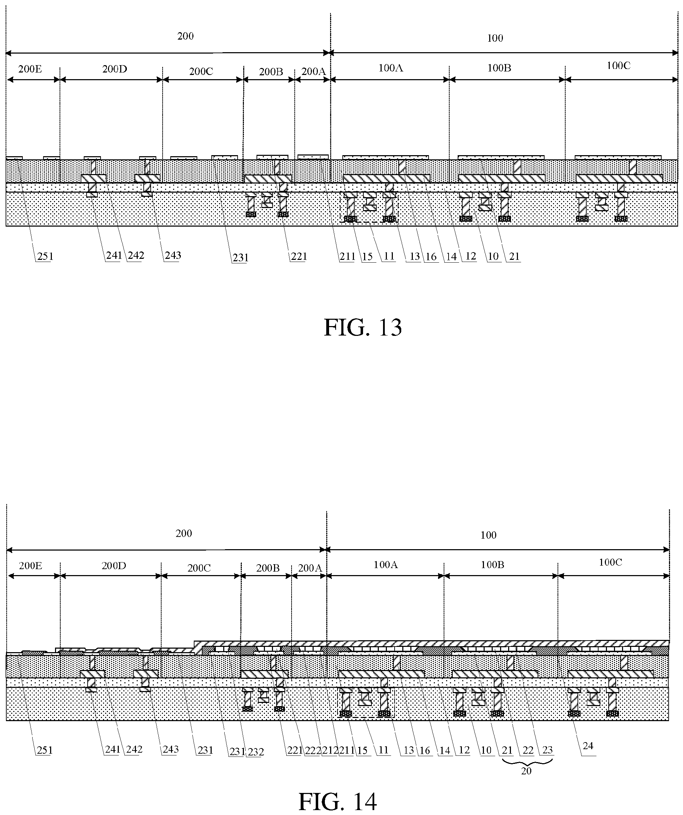

Step S3 includes: forming on the array structure layer a first electrode 21 located in the display area 100, a first connection electrode 211 located in the first area 200A, a second connection electrode 221 located in the second area 200B, a third connection electrode 231 located in the third area 200C, a fourth connection electrode 243 located in the fourth area 200D and a fifth connection electrode 251 located in the fifth area 200E, as shown in FIG. 13.

Step S4 includes: forming a pixel definition layer 24 on the array structure layer on which the first electrode 21 is formed; forming an organic light emitting layer 22 located in display area 100, a first organic light emitting layer 212 located in first area 200A, a second organic light emitting layer 222 located in second area 200B and a third organic light emitting layer 232 located in third area 200C on the array structure layer on which the pixel definition layer is formed; forming second electrodes 23 located in the display area 100, the first area 200A, the second area 200B, the third area 200C, the fourth area 200D and part of the fifth area 200E on the array structure layer on which the organic light emitting layers are formed, as shown in FIG. 14.

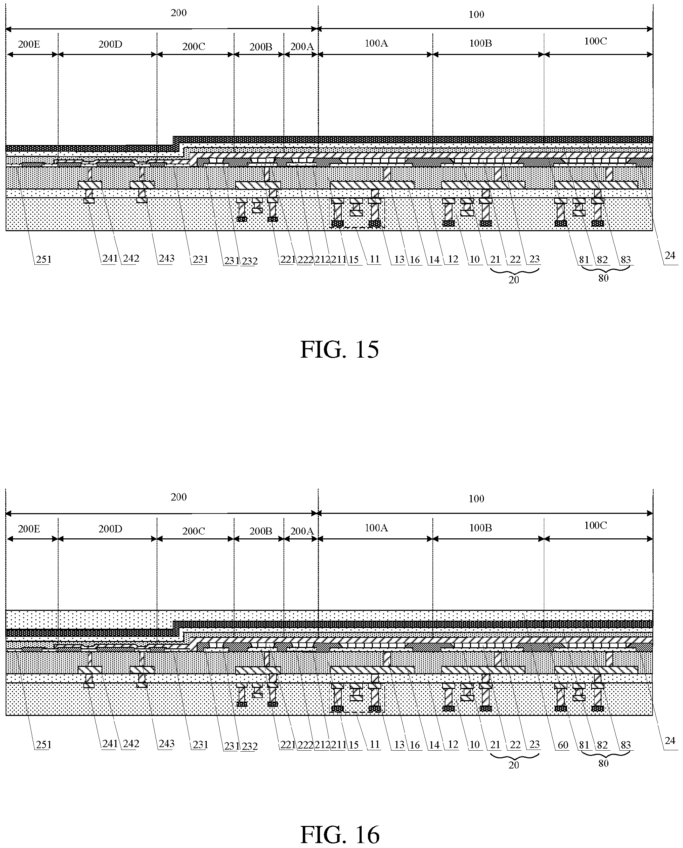

Step S5 includes: forming on the second electrode 23 an encapsulation layer 80 covering the entire display area 100 and the entire peripheral area 200 and including a first inorganic encapsulation layer 81, a second inorganic encapsulation layer 82 and a third organic encapsulation layer 83, as shown in FIG. 15.

Step S6 includes: forming on the encapsulation layer 80 a second flat layer 60 covering the entire display area 100 and the entire peripheral area 200, as shown in FIG. 16.

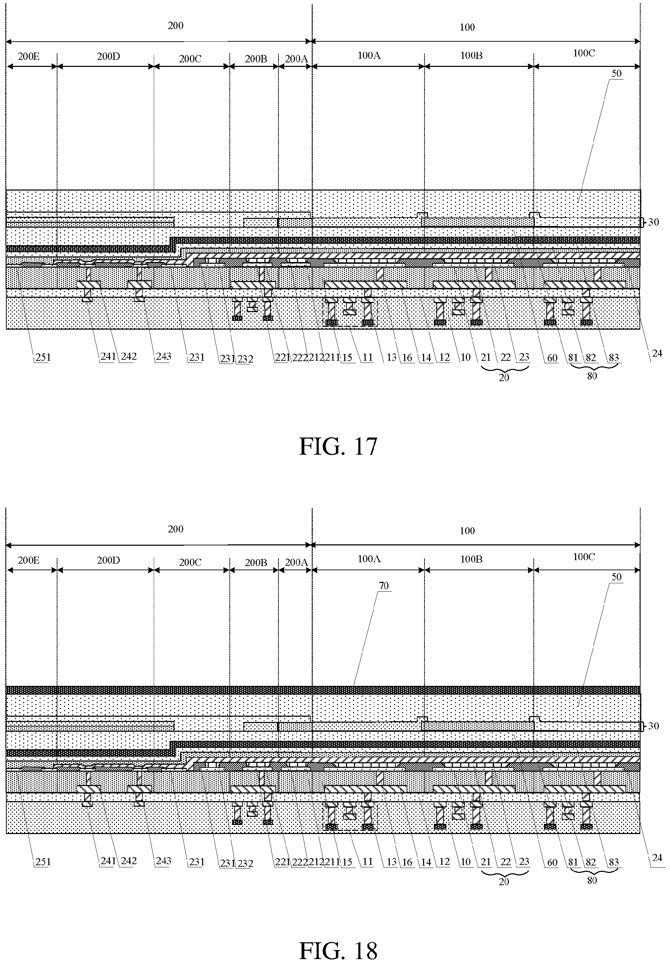

Step S7 includes: forming on the second flat layer 60 a color filter layer 30 located in the display area 100, the first area 200A and the second area 200B, and forming a first flat layer 50 on the color filter layer 30, as shown in FIG. 17.

Step S8 includes: forming on the first flat layer 50 an optical base layer 70 covering the entire display area 100 and the entire peripheral area 200, as shown in FIG. 18.

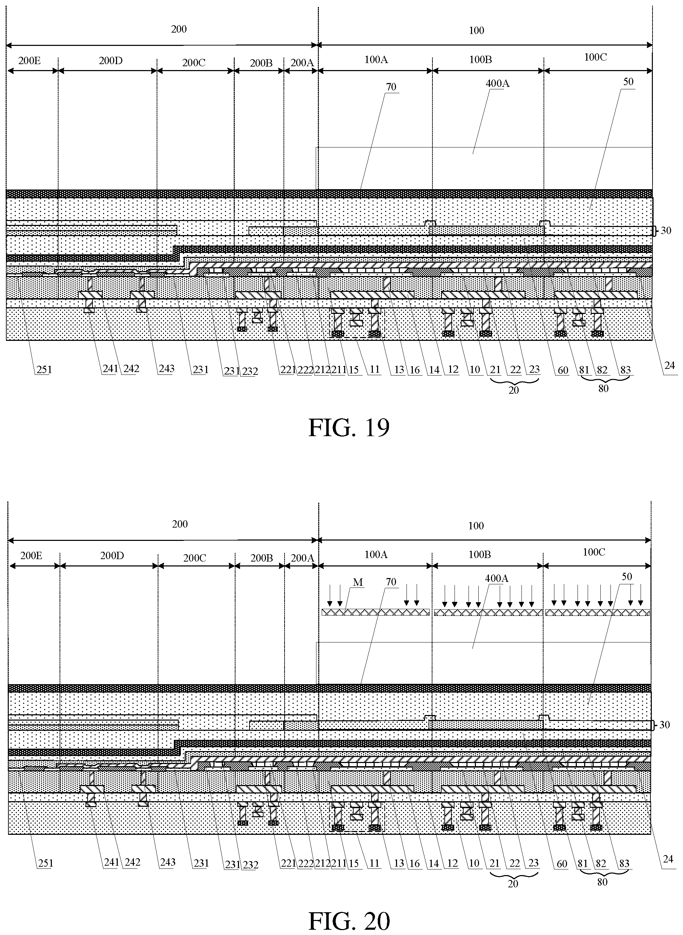

Step S9 includes: coating a photoresist thin film 400A onto the optical base layer 70, as shown in FIG. 19.

Step S10 includes: exposing the photoresist thin film 400A by using a mask M, to enable the photoresist thin film to include an exposed area and a non-exposed area, as shown in FIG. 20.

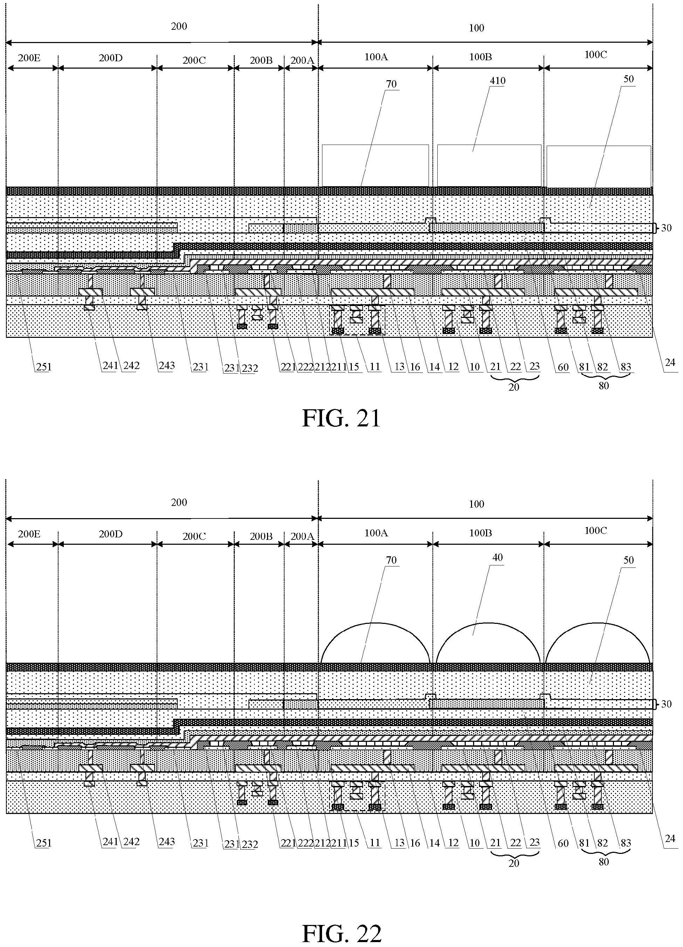

Step S11 includes: removing the mask, developing the photoresist thin film 400A, and removing the photoresist thin film in the exposed area to form an initial optical layer 410, as shown in FIG. 21.

Step S12 includes: baking the initial optical layer 410 to form an optical layer 40 including a plurality of optical devices through natural flow of the photoresist thin film, as shown in FIG. 22.

Step S13 includes: coating a filling adhesive 91 onto one side of the optical layer 40 away from the base substrate 10; and attaching a cover panel 90 to the filling adhesive 91 to form a sealant (not shown) between the cover panel 90 and the base substrate 10, as shown in FIG. 3.

An embodiment of the present disclosure further provides a display apparatus, including the display substrate according to any of the aforementioned embodiments.

In an exemplary embodiment, the display apparatus includes a VR device or an AR device.

The drawings in the present disclosure only refer to the structures involved in the embodiments of the present disclosure, and as to other structures, reference may be made to general designs.

For the sake of clarity, the thickness and size of layers or microstructures are exaggerated in the drawings used to describe the embodiments of the present disclosure. It will be understood that when an element such as a layer, film, region or substrate is referred to as being "on" or "under" another element, the element may be "directly" "on" or "under" the another element, or there may be an intervening element.

Although the embodiments disclosed in the present disclosure are as described above, the described contents are only the embodiments for facilitating understanding of the present disclosure, which are not intended to limit the present disclosure. A person skilled in the art to which the present disclosure pertains may make any modifications and variations in the form and details of implementation without departing from the spirit and scope of the present disclosure. Nevertheless, the scope of patent protection of the present disclosure shall still be determined by the scope defined by the appended claims.

## Claims

1. A display substrate, comprising: a display area and a peripheral area surrounding the display area, the display substrate comprising: a base substrate, and a light emitting structure layer, a color filter layer, a first flat layer and an optical layer disposed on the base substrate; the color filter layer being located on one side of the light emitting structure layer away from the base substrate, the first flat layer being located on one side of the color filter layer away from the base substrate, and the optical layer being located on one side of the first flat layer away from the base substrate and being configured to collect light emitted from the color filter layer;
the display substrate further comprising a transistor, an active layer of the transistor being formed in an interior of the base substrate;
a surface of the color filter layer, located in the display area, away from the base substrate being uneven; a first thickness being a maximum thickness of the color filter layer located in the display area, and a second thickness being a minimum thickness of the color filter layer located in the display area; and
a difference between the first thickness and the second thickness being smaller than or equal to a thickness of the first flat layer.

2. The display substrate according to claim 1, wherein the optical layer comprises: a plurality of optical elements, and the light filters correspond to the optical elements one by one; and
an orthographic projection of the light filter on the base substrate covers an orthographic projection of a corresponding optical element on the base substrate, and a projection area of the light filter on the base substrate is greater than a projection area of a corresponding optical element on the base substrate.

3. The display substrate according to claim 2, wherein the display substrate further comprises: a second flat layer; and
the second flat layer is located between the light emitting structure layer and the color filter layer.

4. The display substrate according to claim 3, wherein the display substrate further comprises: an optical base layer; and
the optical base layer is located between the first flat layer and the optical layer and is configured to adhere the optical layer to the first flat layer.

5. The display substrate according to claim 1, wherein the plurality of optical elements are arranged at intervals and arranged in a matrix;
an interval between adjacent optical elements is smaller than a length of the optical element in a direction perpendicular to the base substrate, and is 0.2 microns to 0.4 microns;
the length of the optical element in the direction perpendicular to the base substrate is smaller than a length of the optical element in an extending direction of the base substrate; and
the length of the optical element in the direction perpendicular to the base substrate is 1 micron to 2 microns, and the length of the optical element in the extending direction of the base substrate is 2 microns to 4 microns.

6. The display substrate according to claim 5, wherein the optical element is a lens; and a shape of the lens comprises: a hemisphere.

7. The display substrate according to claim 3, wherein lengths of the first flat layer and the second flat layer in a direction perpendicular to the base substrate are 0.3 microns to 0.5 microns;
the length of the first flat layer in the direction perpendicular to the base substrate is greater than the length of the second flat layer in the direction perpendicular to the base substrate; and
the length of the first flat layer in the direction perpendicular to the base substrate is smaller than the length of the optical element in the direction perpendicular to the base substrate.

8. The display substrate according to claim 7, wherein a shape of the light filter comprises: a hexagon, and the plurality of light filters are arranged in an array; and
the second thickness is 1.5 microns to 2.5 microns, and the difference between the first thickness and the second thickness is 0.2 microns to 0.4 microns.

9. The display substrate according to claim 1, wherein the display substrate further comprises: an array structure layer; and the array structure layer is located between the base substrate and the light emitting structure layer.

10. The display substrate according to claim 4, wherein
the display substrate further comprises: an encapsulation layer;
the encapsulation layer is located on one side of the light emitting structure layer close to the second flat layer;
the encapsulation layer comprises: a first inorganic encapsulation layer, a second inorganic encapsulation layer and a third organic encapsulation layer;
the first inorganic encapsulation layer is located on one side of a second electrode away from the base substrate;
the second inorganic encapsulation layer is located on one side of the first inorganic encapsulation layer away from the base substrate; and
the third organic encapsulation layer is located on one side of the second inorganic encapsulation layer away from the base substrate.

11. The display substrate according to claim 10, wherein a manufacturing material of the third organic encapsulation layer is the same as a manufacturing material of the optical base layer.

12. The display substrate according to claim 1, wherein
the display substrate further comprises: a cover panel and a filling adhesive;
the cover panel is located on one side of the optical layer away from the base substrate; and
the filling adhesive is filled between the cover panel and the optical layer.

13. The display substrate according to claim 4, wherein
the display substrate further comprises: a binding area;
the binding area is located on one side of the peripheral area away from the display area;
the color filter layer and the light emitting structure layer are located in the display area and part of the peripheral area; and
the first flat layer, the second flat layer and the optical base layer cover the entire display area and at least part of the peripheral area.

14. A display apparatus, comprising the display substrate according to any one of claims 1-13.

15. A method for manufacturing a display substrate, which is used for manufacturing the display substrate according to any one of claims 1-13, the method comprising:
forming a light emitting structure layer on a base substrate;
forming a color filter layer on one side of the light emitting structure layer away from the base substrate;
forming a first flat layer on one side of the color filter layer away from the base substrate; and
forming an optical layer on one side of the first flat layer away from the base substrate.

16. The method according to claim 15, wherein the forming a light emitting structure layer on a base substrate comprises:
forming an array structure layer on the base substrate;
forming a first electrode on one side of the array structure layer away from the base substrate;
forming a pixel definition layer on one side of the array structure layer, which has the first electrode formed, away from the base substrate; and
forming an organic light emitting layer and a second electrode sequentially on one side of the array structure layer, which has the pixel definition layer formed, away from the base substrate.

17. The method according to claim 16, wherein the forming a color filter layer on one side of the light emitting structure layer away from the base substrate comprises:
forming an encapsulation layer on one side of the light emitting structure layer away from the base substrate;
forming a second flat layer on one side of the encapsulation layer away from the base substrate; and
forming the color filter layer on one side of the second flat layer away from the base substrate.

18. The method according to claim 16, wherein the forming an optical layer on one side of the first flat layer away from the base substrate comprises:
forming an optical base layer on one side of the first flat layer away from the base substrate; and
forming the optical layer on one side of the optical base layer away from the base substrate.

19. The method according to claim 18, wherein the forming the optical layer on one side of the optical base layer away from the base substrate comprises:
coating a photoresist thin film onto one side of the optical base layer away from the base substrate;
treating the photoresist thin film by a photolithography process to form an initial optical layer; and
baking the initial optical layer to form an optical layer comprising a plurality of optical elements.

20. The method according to claim 19, wherein the treating the photoresist thin film by a photolithography process comprises:
exposing the photoresist thin film by using a mask to enable the photoresist thin film to comprise an exposed area and a non-exposed area; an orthographic projection of the pixel definition layer on the base substrate covering an orthographic projection of the exposed area on the base substrate, and a width of the exposed area being smaller than an interval between two adjacent optical devices; and
removing the mask, developing the photoresist thin film, and removing the photoresist thin film located in the exposed area.

21. The method according to claim 15, wherein after the forming an optical layer on one side of the color filter layer away from the base substrate, the method further comprises:
coating a filling adhesive onto one side of the optical layer away from the base substrate; and
attaching a cover panel to the filling adhesive.
